# EUROPÄISCHE PATENTSCHRIFT

(11) **EP 1 703 781 B1**
(45) Veröffentlichungstag und Bekanntmachung des Hinweises auf die Patenterteilung: **24.09.2008**
(21) Anmeldenummer: 05405246.9
(22) Anmeldetag: 16.03.2005
(51) Int. Cl.: H05K 1/16, H01C 7/06, H01C 7/00

(54) **Verfahren zum Herstellen eines elektrischen Verbindungselementes, sowie Verbindungselement**
Manufacturing method for an electrical connection element
Procédé de fabrication d'un élément de connexion électrique

(43) Veröffentlichungstag der Anmeldung: 20.09.2006
(73) Patentinhaber: Dyconex AG, 8303 Bassersdorf (CH)
(72) Erfinder: Sabev, Pavlin, 8049 Zürich (CH)
(74) Vertreter: Frei Patent Attorneys

(56) Entgegenhaltungen:
- WO-A-99/27759
- US-A- 5 403 768
- US-A- 5 709 927
- US-A1- 2003 150 840
- US-A1- 2003 162 386
- US-A1- 2004 192 039
- US-B1- 6 500 724

## Beschreibung

Die Erfindung betrifft das Gebiet der elektrischen Verbindungselemente. Bei solchen handelt es sich um Verdrahtungssysteme für eine Anordnung von aktiven und/oder passiven elektrischen bzw. elektronischen Bauteilen. Beispiele für elektrische Verbindungselemente sind Leiterplatten (printed circuit boards), ,High Densitiy Interconnects' (HDIs), Flex-Prints, interposer, etc.. Konkret betrifft die Erfindung elektrische Verbindungselemente mit eingebetteten Widerständen sowie deren Herstellung.

Leiterplatten mit beispielsweise netzwerkartig eingebetteten elektrischen Widerständen sind bekannt. Es ist beispielsweise bekannt, in Leiterplattenmaterialien eine Widerstandsschicht einzuschliessen, aus welcher durch selektives Ätzen ein Netzwerk von elektrischen Widerständen erzeugt werden kann. Eine solche Widerstandsschicht besteht beispielsweise aus einer Nickellegierung. Es stellt sich aber das Problem der mangelnden Ätzmittelselektivität beim Ätzen der Widerstandsschicht bzw. der daran haftenden Kupferschicht, über die die Kontaktierung der Widerstände erfolgt. Ausserdem liegt bei den genannten Leiterplattenmaterialien eine Nickelschicht direkt an einer Kunststoffsubstratschicht an. Die Haft-Eigenschaften von Nickellegierungen an Kunststoffschichten sind aber nicht sehr gut. Daher kann sich die Widerstandsschicht im ungünstigsten Fall ablösen. Ausserdem sieht herstellungstechnisch bedingt nur ein beschränkter Dickenbereich zur Verfügung; es lassen sich für die erwähnten Leiterplattenmaterialien nicht beliebig dünne Nickelschichten herstellen.

Aus der US-Patentschrift 5 403 68 ist ein Verfahren zur Herstellung eines Dünnfilmwiderstands mittels lithografischer Strukturierung einer Metallschicht bekannt. Das Verfahren beinhaltet eine grössere Anzahl notwendiger Verfahrensschritte. Die Schrift US 2004/0192039 offenbart ein Verfahren zum Herstellen eines Mehrschicht-Leiterplatte mit integrierten Polymer-Widerständen.

Aus diesem Grund stellt sich der Erfindung die Aufgabe, ein Verfahren zum Herstellen von elektrischen Verbindungselementen sowie ein elektrisches Verbingungselement zur Verfügung zu stellen, welches Nachteile gemäss dem Stand der Technik überwindet und welches insbesondere ohne einen grossflächigen Übergang zwischen einer Isolatorschicht und einer Nickelschicht auskommt.

Diese Aufgabe wird gelöst durch ein Verfahren mit der Merkmalen des Anspruchs 1 und ein Verbindungselement mit den Merkmalen des Anspruchs 6.

Das erfindungsgemässe Verfahren zeichnet sich im Wesentlichen dadurch aus, dass an einer ersten strukturierten Leiterschicht - sie kann aus Kupfer oder einer Kupferlegierung bestehen - ein Widerstandsmaterial - beispielsweise Nickel oder eine Nickellegierung -angelagert wird. Anschliessend wird die erste strukturierte Leiterschicht zumindest an denjenigen Stellen wieder entfernt, an denen ein Widerstand entstehen soll. Dies geschieht, indem an den gewünschten Stellen zuerst von einer Rückseite her das isolierende Material, auf dem die erste Leiterschicht haftet, entfernt wird, beispielsweise mittels Plasma-Ätzverfahren. Dabei hilft ein Träger bei der mechanischen Stabilisierung. Anschliessend kann die erste Leiterschicht mindestens bereichsweise entfernt werden. Auf der zweiten Seite der isolierenden Schicht ist eine zweite strukturierte Leiterschicht vorhanden oder wird während des Verfahrens erzeugt. Der Widerstand wird durch Durchsteiger (Vias) von der zweiten strukturierten Leiterschicht her kontaktiert.

Das Anlagern des Widerstandsmaterials am ersten Leitermaterial erfolgt oberflächenselektiv, d.h. das Widerstandsmaterial lagert sich nur am ersten Leitermaterial, nicht aber an frei liegenden Oberflächen des isolierenden Materials. Es existieren bereits Verfahren, die das ermöglichen. Eine besonders bevorzugte Variante ist die autokatalytische Abscheidung, wie sie beispielsweise für Nickel auf Gold an sich bekannt ist. Eine weitere Möglichkeit ist das galvanische Abscheiden eines Widerstandsmaterials auf dem ersten Leitermaterial, wobei dann die Strukturen des ersten Leitermaterials so gewählt sind, dass sie an den gewünschten Stellen elektrisch kontaktierbar sind.

Die strukturierte erste Leiterschicht dient gemäss obigem Konzept mindestens bereichsweise quasi als "Spurschicht": sie bestimmt, wo später die Widerstände verlaufen sollen, und wird nach der Anlagerung des Widerstandsmaterials mindestens teilweise wieder entfernt.

Im Unterschied zum Stand der Technik wird also das zweite Leitermaterial (das Widerstandsmaterial, beispielsweise das Nickel bzw. die Nickellegierung) an einer strukturierten Leiterschicht selektiv angelagert. Es bildet sich von vornherein nur an gewünschten Stellen eine Schicht aus dem Widerstandsmaterial. Nach einem Aufbringen des Schichtsystems auf einem Träger - beispielsweise durch Kleben/Laminieren ― gibt es daher nur an diesen gewünschten Stellen einen Übergang zwischen Kunststoff und dem Widerstandsmaterial. Nicht sehr gute Haft-Eigenschaften des Widerstandsmaterial spielen aus diesem Grund keine oder nur eine untergeordnete Rolle.

Um dem Aufbau mechanische Stabilität zu verleihen, wenn die isolierende Schicht lokal entfernt wird, wird das Schichtsystem nach dem Strukturieren der Leiterschicht und Anlagern des Widerstandsmaterials aber vor dem Entfernen des isolierenden Materials auf einem Träger befestigt, so, dass die Seite mit der strukturierten Leiterschicht und mit dem angelagerten Widerstandsmaterial auf dem Träger aufliegt. Der Träger muss nicht grossflächig-durchgehend sein; er sollte in dieser Ausführungsform aber mindestens dort vorhanden sein, wo die Widerstände entstehen sollen. Vorzugsweise ist der Träger formsteif oder er besitzt dort steife Abschnitte, wo die entstehenden Widerstände liegen. Das ermöglicht die Verwendung von Widerstandsmaterialien, die nicht auf sich biegenden Substraten haften. Der Träger kann beispielsweise aus faserverstärktem Material gefertigt sein.

Nachdem das isolierende Material und das erste Leitermaterial an den gewünschten Stellen entfernt worden sind, liegt das zweite Leitermaterial - das Widerstandsmaterial ― zu einer Seite hin frei, quasi in 'Fenstern' im isolierenden Material. Dies ermöglicht, eine lasergestützte Widerstandswertangleichung: Mittels eines Laserstrahls wird die Breite einer Übergangsportion des Widerstandes (d..h. des den eigentlichen Widerstand ausmachenden, meist länglich-schmalen Abschnitts zwischen den Endportionen) an einer oder mehreren stellen gezielt reduziert, bis ein gewünschter Widerstandswert erreicht ist.

Das erfindungsgemässe Verfahren ermöglicht im Unterschied zum Stand der Technik aber auch, den Widerstandswert durch die Dicke des Widerstandsmaterials gezielt zu beeinflussen: es steht nicht nur eine kleine Menge von festen Widerstandsfoliendicken zur Verfügung, aus denen ausgewählt werden kann, sondern die Dicke der Widerstandsschicht kann in einem breiten Bereich frei gewählt werden. Ein elektrisches Verbindungselement kann auch (bspw. in derselben Schicht) elektrische Widerstände unterschiedlicher Dicke aufweisen. Dies kann mittels der Maskentechnik bewerkstelligt werden: in einem ersten Schritt wird Widerstandsmaterial bis zu einer bestimmten ersten Dicke an der strukturierten Leiterschicht angelagert. Anschliessend wird eine Maske aufgebracht, welche Teile der strukturierten Leiterschicht abdeckt, woraufhin erneut Widerstandsmaterial bis zu einer zweiten Dicke angelagert wird. Dieser Vorgang kann wiederholt werden, um Widerstände unterschiedlichster Dicken zu erzeugen.

Ein elektrisches Verbindungselement oder Halbfabrikat gemäss der Erfindung besitzt einen Schichtaufbau mit Leiterstrukturen aus einem ersten Leitermaterial (meist Kupfer) und mit mindestens einem eingebetteten Widerstand aus einem Widerstandsmaterial. Es unterscheidet sich vom bekannten Stand der Technik dadurch, dass der Widerstand durch eine strukturierte Lage aus dem Widerstandsmaterial gebildet wird, welche im Schichtaufbau zwischen zwei isolierenden Schichten ausgebildet ist.

"Im Schichtaufbau zwischen zwei isolierenden Schichten ausgebildet" bedeutet nicht, dass die Schicht mit dem Widerstandsmateterial vollständig zwischen den zwei Schichten eingebettet sein muss. Im Gegenteil, wie aus obiger Beschreibung des Herstellungsverfahrens hervorgeht, wird die erste isolierende Schicht vorzugsweise im Herstellungsverfahren dort lokal entfernt, wo der Widerstand liegt. Vielmehr ist gemeint, dass das Widerstandsmaterial an einer elektrisch isolierenden Schicht haftet, welche Schicht im Schichtaufbau flächig - also bspw. über einen ganzen Bereich des Verbindungselementes oder über das ganze Verbindungselement - an einer weiteren elektrisch isolierenden Schicht haftet, wobei die Grenzfläche zwischen den beiden isolierenden Schichten nur lokal (insbesondere in Umgebungen des Widerstandes/der Widerstände) unterbrochen ist.

An Endportionen des Widerstandes/der Widerstände umhüllt das Widerstandsmaterial teilweise erstes Leitermaterial. Dies wird dadurch erreicht, dass im Herstellungsverfahren das als Spurschicht dienende erste Leitermaterial im Bereich der Endportionen nicht entfernt wird. Dieses Merkmal bringt den Vorteil mit sich, dass dadurch eine zuverlässige Kontaktierung des Widerstandes über Durchsteiger möglich ist. Wenn als erstes Material und als Durchsteiger-Material Kupfer gewählt wird, wird der Widerstand über eine verlässliche Cu-Cu-Verbindung kontaktiert.

Der Widerstand kann auch durch Leiterbahnen kontaktiert sein, welche in derselben Schicht angeordnet sind. Beispielsweise kann die erste Leiterschicht im Herstellungsverfahren nur Bereichsweise als Spurschicht dienen und in anderen Bereichen eine konventionelle Leiterbahnstruktur bilden. Diese anderen Bereiche können bspw. während des Abscheidens des Widerstandsmaterials geeignet abgedeckt sein.

Im Folgenden werden Ausführungsformen des erfindungsgemässen Verfahrens anhand von Zeichnungen beschrieben. In den Zeichnungen zeigen:
- Fig. 1 ein Ausgangsprodukt, nämlich ein beidseitig mit Kupfer beschichtete elektrisch isolierende Schicht in einem Längsschnitt,
- Fig. 2 das Ausgangsprodukt nach einem Vorbearbeitungsschritt,
- Fig. 3a das Produkt nach einer Strukturierung,
- Fig. 3b eine Struktur der ersten Lage in Draufsicht,
- Fig. 4 eine Anordnung von zwei Produkten gemäss Fig. 3a während der Beschichtung mit einem Widerstandsmaterial,
- Fig. 5 das Produkt nach der Beschichtung mit dem Widerstandsmaterial, auf einen Träger auflaminiert,
- Fig. 6 das Produkt nach Entstehen der Durchsteiger,
- Fig. 7a und 7b das Entfernen der elektrisch isolierenden Schicht,
- Fig. 8 die daran anschliessende Strukturierung der zweiten Leiterschicht,
- Fig. 9 die entstandene Struktur nach dem selektiven Ausätzen des Kupfers in einem Querschnitt.

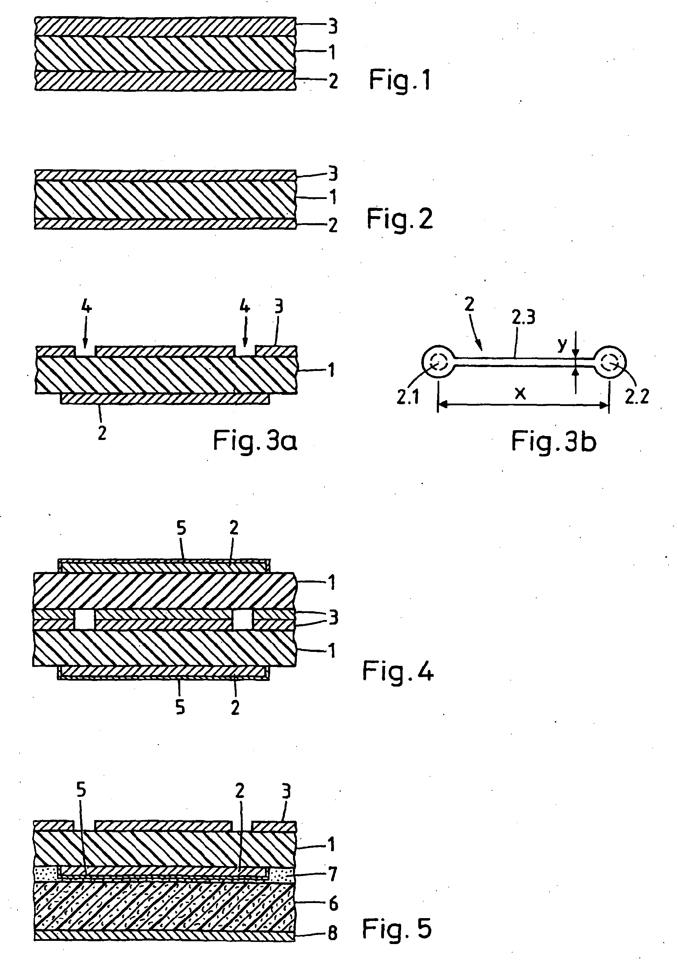

Das in **Figur 1** gezeichnete Ausgangsprodukt kann ein an sich bekanntes, beispielsweise kommerziell erhältliches Produkt sein. Es kann eine beidseitig kupferkaschierte Polyimid-, Epoxyd-, PET-, PEEK-, PES- oder LCP-Folie sein; im Prinzip ist irgend ein i.A. beidseitig mit einem ersten Leitermaterial versehenes isolierendes Material geeignet. Die Folie 1 wird auch als isolierende Schicht bezeichnet, die in der Figur untere Kupferkaschierung 2 als erste Leiterschicht und die obere Kupferkaschierung 3 als zweite Leiterschicht.

In einem optionalen ersten Verfahrensschritt wird beispielsweise Leitermaterial von den beiden Leiterschichten abgetragen (Cu-Reduktion), um eine gewünschte Leiterdicke zu erreichen, wie das in **Figur 2** dargestellt ist. Die optimale Leiterdicke hängt von der Anwendung ab. Das erfindungsgemässe Verfahren ermöglicht aber das Arbeiten mit verhältnismässig dicken Leiterschichten von zwischen 10 µm und 50 µm, vorzugsweise zwischen 20 µm und 40 µm. Dies ist vorteilhaft, da die stromführenden Leiterbahnen nicht breit sein müssen und trotzdem verhältnismässig grosse Ströme leiten können.

Die erste und zweite Leiterschicht werden in einem ersten Strukturierungsschritt strukturiert, was in **Figur 3a** und **3b** dargestellt ist.. Die erste Leiterschicht 2 erhält dabei Leiterbahnen an denjenigen Stellen, an denen später ein Widerstand entstehen soll. Eine entsprechende Leiterbahn ist in Figur 3b in Draufsicht gezeigt. Die Leiterbahn besitzt zwei Endportionen 2.1, 2.2 und eine Übergangsportion 2.3. Die erste Leiterschicht kann Leiterbahnen verschiedener Formen und Ausgestaltungen aufweisen, beispielsweise in verschiedenen Längen (x) und Breiten (y). Sie kann auch eine abgewinkelte, mäandrierende oder andere kompliziertere Form aufweisen. Gemäss einer speziellen Ausführungsform sind die Leiterbahnen ― und folglich die später entstehenden Widerstände - in einem regelmässigen Raster angeordnet. Andere Ausfürungsformen sehen vor, dass Leiterbahnen in einem bestimmten, anwendungsabhängigen Muster vorliegen. Beispielswiese kann für ein als 'Interposer' (Verbindungselement zur Kontaktierung einer komplexen integrierten Schaltung-,Chip') dienendes elektrisches Verbindungselement ein Widerstandsnetzwerk gefertigt werden, das passend zur Konfiguration der integrierten Schaltung ausgestaltet ist.

Die erste Leiterschicht kann neben Leiterbahnen für die spätere Bereitstellung von Widerständen auch andere Strukturen erhalten, beispielsweise abschnittsweise anwendungsspezifische oder rasterartige Leiterbahnstrukturen die in konventioneller Weise als Leiterverbindungen dienen sollen, oder flächige Strukturen, die zusammen mit entsprechenden Strukturen in einer benachbarten Schicht ein kapazitives Element bilden.

Die zweite Leiterschicht 3 wird bspw. in dem ersten Strukturierungsschritt mit Öffnungen 4 an denjenigen Stellen versehen, an denen Durchsteiger (Vias) entstehen sollen. Je nach Technik für die Erzeugung von Vias kann der erste Strukurierungsschritt für die zweite Leiterschicht auch ganz entfallen, beispielsweise wenn die Vias mechanisch gebohrt werden.

In einem nächsten, in **Figur 4** dargestellten Verfahrensschritt wird die strukturierte erste Leiterschicht 2 mit einem Widerstandsmaterial versehen, nämlich mit einer Ni-P-Legierung. Während diesem Beschichtungsschritt wird die zweite Leiterschicht 3 in geeigneter Weise abgedeckt, damit sie frei von Nickel bleibt. Das kann wie dargestellt geschehen, indem zwei Exemplare des Produktes gemäss Fig. 3a leicht aneinandergepresst werden, und zwar in einer Anordnung, in denen die ersten Leiterschichten aneinander anliegen. Alternativ dazu kann die zweite Leiterschicht auch auf andere Weise geschützt werden, beispielsweise durch Anbringen einer leicht haftenden, anschliessend wieder entfernbaren Folie, durch Anpressen an eine Fläche eines Hilfselementes etc.

Der Beschichtungsschritt erfolgt so, dass das Widerstandsmaterial 5 nur am ersten Leitermaterial, nicht aber an frei liegenden Kunststoffoberflächen anhaftet. Gemäss einer bevorzugten Ausführungsform erfolgt das Beschichten mit dem Widerstandsmaterial autokatalytisch. Nickel lässt sich autokatalytisch aus einem Bad abscheiden, welches gelöste Nickelionen enthält. Entsprechende Verfahren sind beispielsweise für die Herstellung von Au/Ni-Endschichten auf Leiterplatten von Mobiltelefonen bekannt, und es wird hier nicht näher darauf eingegangen. Für das Bad kann bspw. das unter dem Handelsnamen Duraposit vertriebene Produkt der Firma Shipley oder irgend eine andere geeignete Chemikalie verwendet werden. Das in einem solchen Verfahren abgeschiedene Widerstandsmaterial enthält neben dem Nickel auch Phosphor in recht grossen Konzentrationen. Das ist an sich vorteilhaft, da das Widerstandsmaterial ja einen Widerstand bilden soll: je grösser der Flächenwiderstand desto besser. Das Anlagern des Widerstandsmaterials kann alternativ zum beschriebenen autokatalytischen Prozess auch galvanisch erfolgen.

Die Dicke der entstehendenSchicht kann durch die Zeit gesteuert werden, während der Nickel abgeschieden wird. Sie kann beispielsweise zwischen 2 µm und 5 µm betragen. Sie kann auch dicker als 5 µm oder noch dünner als 2 µm sein.

Daraufhin wird das entstandene Produkt auf einen Träger 6 auflaminiert (Kleberschicht 7). Dieser Schritt ist in **Figur 5** dargestellt. Im dargestellten Beispiel ist der Träger eine einseitig mit Kupfer kaschierte Faserverbundplatte ( auf die Kupferschicht weist das Bezugszeichen 8 hin). Er kann aber auch irgend ein anderes Element sein, das die Leiterschichten in den folgenden Bearbeitungsschritten stützen kann, beispielsweise eine anders zusammengesetzte Platte oder Folie, eine vorgefertigte Leiterplatte, eine Wärmesenke etc.

Der Träger muss nicht über die ganze Fläche des entstehenden elektrischen Verbindungselementes ausgedehnt sein. Sie wird in der hier beschriebenen Ausführungsform lediglich an den Stellen der Widerstände benötigt. Dazwischen kann sie entfallen, so dass das elektrische Verbindungselement flexible und steife Abschnitte aufweisen kann.

Gemäss einer bevorzugten Ausführungsform ist der Träger 6 mindestens abschnittweise steif (wie das bei einer Faserverbundplatte der Fall ist). Dann ist sichergestellt, dass sich das Widerstandsmaterial nicht aufgrund von Biegungen des Trägers ablösen oder brechen kann. In anderen Ausführungsformen wird sogenanntes flexibles Nickel oder ein anderes Widerstandsmaterial verwendet, welches Biegungen des Substrates aushält. In diesen Ausführungsformen kann der Träger aus ganz biegbarem Material sein (,Full-Flex').

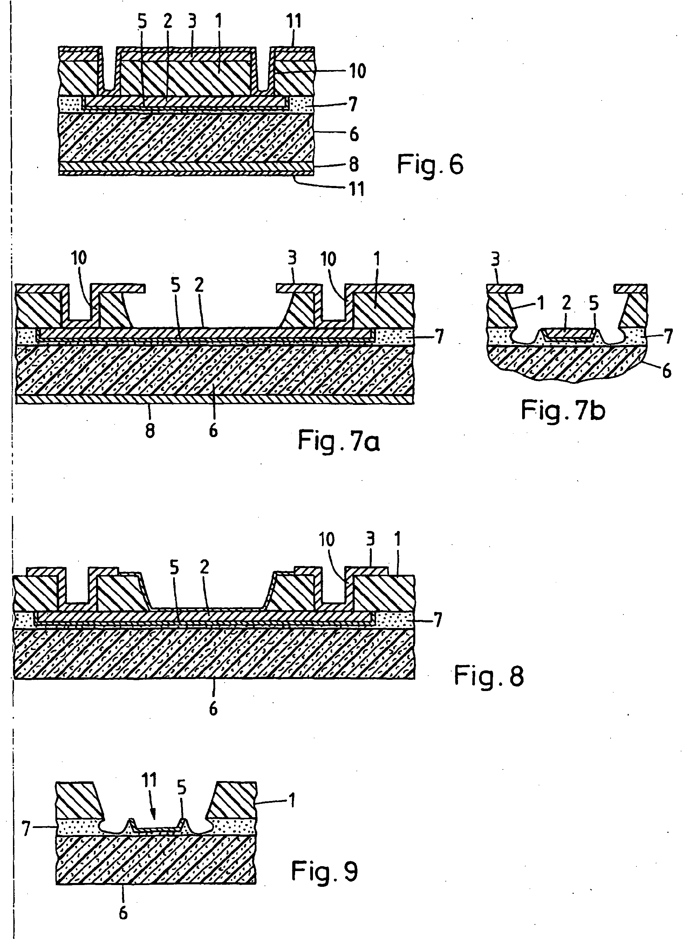

Anschliessend an das Aufbringen des Produkts auf den Träger werden Durchsteiger 10 von der zweiten Leiterschicht gefertigt. Dieser Schritt ist in **Figur 6** dargestellt. Die Herstellung von Durchsteigern kann auf viele Arten geschehen, beispielsweise durch Laserbohren, mechanisches Bohren, einstechen ("piercing") oder Lochherstellung mittels Plasmaätzen und dem anschliessenden chemischen Abscheiden einer kontaktierenden Kupferschicht 11, etc.. Die Durchsteiger 10 können eventuell auch vor dem Aufbringen auf den Träger erzeugt werden, beispielsweise mit der ALIVH (Any Layer Interstitial Via Hole)-Technik, die von der Firma Matsushita entwickelt wurde.

Als nächster Schritt wird die isolierende Schicht 1 selektiv an denjenigen Stellen entfernt, an denen das Widerstandsmaterial 5 einen eingebetteten elektrischen Widerstand bilden soll. Zu diesem Zweck wird zuerst an besagten Stellen die zweite Leiterschicht 3 entfernt. Anschliessend wird, wie in **Figur 7a und 7b** gezeigt, das isolierende Material in einem Ätzverfahren, beispielsweise einem Plasmaätzverfahren, entfernt. In diesem Ätzverfahren dient die zweite Leiterschicht 3 als Maske, d.h. das Kupfer wird nicht angegriffen. Ein solches Plasmaätzverfahren ist beispielsweise unter dem Handelsnamen Dycostrate® bekannt und dokumentiert. Die Stellen, an denen das isolierende Material weggeätzt wird, müssen dabei so ausgewählt werden, dass die Durchkontaktierungen nicht berührt sind: dort soll das erste Leitermaterial verbleiben und ein Kontaktieren des Widerstandes von der benachbarten Lage her ermöglichen. Die entsprechenden für die Kontaktierung dienenden Endportionen 2.1, 2.2 sind in Figur 3b verbreitert gezeichnet. Dadurch hat das an den Endportionen verbliebene erste Leitermaterial quasi die Wirkung einer Kontaktierungsschicht: die Durchkontaktierungen resultieren in einem elektrischen Kontakt zwischen zwei Schichten des ersten Leitermaterials (also bspw. einem Cu-Cu-Kontakt). Ein solcher ist bekanntlich mit hoher Zuverlässigkeit herstellbar. In Fig. 7a sind aus Gründen der übersichtlichen Darstellung die Durchsteiger 10 etwas breiter dargestellt als in den vorangehenden Figuren, ausserdem werden die zwei Kupferschichten 3, 11 nicht mehr unterschieden.

In der Schnittdarstellung von Figur 7a und der senkrecht Darstellung in Figur 7b, die einen Schnitt senkrecht zur Widerstands-Längsachse zeigt, sieht man die für das Plasmaätzverfahren typischen Hinterätzungen. Das Plasmaätzverfahren wird so lange durchgeführt, bis die erste isolierende Schicht vollständig abgetragen ist. Das faserverstärkte Trägermaterial wird durch das Plasmaätzverfahren nicht angegriffen.

**Figur 8** zeigt das Produkt nach dem nächsten Schritt, nämlich nach dem Strukturieren der zweiten Leiterschicht. Auch die Kupferschicht 8 auf dem Träger kann strukturiert werden und ein Leiterbahnmuster erhalten. Es kann auch Durchkontaktierungen von der zweiten Leiterschicht 3 oder eventuell von der ersten Leiterschicht 2 zu dieser Kupferschicht 8 - der dritten Leiterschicht - geben. Diese können bspw. durch mechanisches Bohren oder mittels Laserbohren oder mit irgend einer anderen geeigneten Technik hergestellt werden.

Gleichzeitig oder anschliessend wird an denjenigen Stellen, an denen das isolierende Material entfernt wurde, das nun frei liegende Material der ersten Leiterschicht 2 entfernt. In diesem Vorgang wird ein Ätzmittel verwendet, welches nur das erste Leitermaterial (Kupfer), nicht aber das zweite Leitermaterial (d.h. das Widerstandsmateral, hier Nickel) angreift. Ein solches Ätzmittel ist beispielsweise als alkalisches, auf Ammoniumnitrat basierendes Ätzmittel erhältlich. Während diesem Verfahrensschritt muss das (eventuell schon strukturierte) Material der zweiten Leiterschicht geeignet geschützt, beispielsweise durch Photolack abgedeckt, werden. Wenn das teilweise Abtragen der zweiten Leiterschicht mit dem Strukturieren gemäss Figur 8 kombiniert wird, wird dies durch die Photolackschicht besorgt, die für die Strukturierung auf der zweiten Leiterschicht 3 aufgetragen ist. Ein Querschnitt durch eine Stelle mit abgeätztem Leitermaterial ist in **Figur 9** im Querschnitt abgebildet. Es bleibt eine Trog-ähnliche Struktur 11 aus Widerstandsmaterial 5.

Anschliessend können die Widerstände bei bedarf in an sich bekannter Art getrimmt werden: Der Widerstandswert wird erhöht, indem mit einem Laser-Schneidewerkzeug der Widerstand (beispielsweise die den eigentlichen Widerstand ausmachende Übergangsportion 2.3) seitlich an einer gewünschten Anzahl Stellen angeritzt wird. Auf das nun resultierende Produkt kann eine beliebige Anzahl weiterer Isolator-Leiter-Schichtfolgen auflaminiert oder sonstwie befestigt werden, und mit Durchsteigern versehen werden so dass in an sich bekannter Art ein viellagiges elektrisches Verbindungselement entsteht. Weitere Lagen können in der hier beschriebenen Art mit einem Widerstandsnetzwerk versehen sein.

Als weiterer optionaler Verfahrensschritt kann das frei liegende Nickel beispielsweise mit einem Siebdruckverfahren mit einer Korrosions-Schutzschicht versehen werden. Auf vorgesehenen Kontaktstellen kann in an sich bekannter Art eine chemisch abgeschiedene Ni/Au-Beschichtung erfolgen.

Das vorstehend beschriebene Verfahren betrifft ein elektrisches Verbindungselement (Leiterplatte, Interposer, HDI etc.) mit mindestens einem Widerstandsnetzwerk. Mit dem beschriebenen erfindungsgemässen Verfahren kann aber auch ein Produkt (Halbzeug) erzeugt werden, welches ein bestimmtes Netzwerk von - beispielsweise rasterartig angeordneten - Widerständen aufweist und zu einem elektrischen Verbindungselement weiter verarbeitbar ist. Für die Herstellung eines solchen ist der in der Figur 8 gezeichnete Schritt der Strukturierung der zweiten Leiterschicht 3 nicht notwendig. Stattdessen kann das in den Figuren 7a und 7b gezeichnete Produkt mit Durchkontaktierungen zu den Widerständen hin auch als Halbfabrikat verwendet und vom Endabnehmer fertiggestellt werden. Die Widerstände des Halbfabrikats können optional eine Korrosions-Schutzschicht aufweisen. Die Fenster mit lokal entfernter isolierender Schicht 1 können optional aufgefüllt sein.

Das vorstehend beschriebene Verfahren und das daraus resultierende Produkt sind bloße Beispiele für die Ausführung der Erfindung, sie können noch auf vielfältige Weise abgeändert werden.

## Patentansprüche

1. Verfahren zum Herstellen eines elektrischen Verbindungselements oder Halbfabrikats mit mindestens einem elektrischen Widerstand, aufweisend folgende Verfahrensschritte
a. Zur-Verfügung-stellen eines Ausgangsprodukts mit einer elektrisch isolierenden Schicht (1) und einer auf einer ersten Seite daran haftenden ersten Leiterschicht (2) aus einem ersten Leitermaterial
b. Strukturieren der ersten Leiterschicht (2),
c. anlagern eines Widerstandsmaterials (5) selektiv an der strukturierten ersten Leiterschicht (2),
d. aufbringen des dadurch entstandenen Schichtsystems auf einem Träger (6), so, dass die erste Seite der elektrisch isolierenden Schicht dem Träger zugewandt ist,
e. entfernen des ersten Leitermaterials und der isolierenden Schicht (1) an denjenigen Stellen, an denen der mindestens eine elektrische Widerstand ausgebildet sein soll,
wobei auf der zweiten Seite der isolierenden Schicht eine zweite strukturierte Leiterschicht (3) vorhanden ist oder erzeugt wird, und wobei der Widerstand durch Durchsteiger (Vias) von der zweiten strukturierten Leiterschicht her kontaktiert wird.

2. Verfahren nach Anspruch 1, **dadurch gekennzeichnet, dass** das selektive Entfernen der isolierenden Schicht mit einem Plasma-Ätzverfahren erfolgt.

3. Verfahren nach Anspruch 1 oder 2, **dadurch gekennzeichnet, dass** das Ausgangsprodukt die auf der zweiten Seite der isolierenden Schicht (1) haftende zweite Leiterschicht (3) aufweist, und dass diese zweite Leiterschicht (3) vor dem selektiven Entfernen der isolierenden Schicht (1) vorstrukturiert wird und beim selektiven Entfernen der isolierenden Schicht (1) als Maske dient.

4. Verfahren nach Anspruch 3, **dadurch gekennzeichnet, dass** die zweite Leiterschicht (3) nach dem selektiven Entfernen der isolierenden Schicht strukturiert wird, so, dass ein Leiterbahnmuster der zweiten strukturierten Leiterschicht (3) entsteht.

5. Verfahren nach einem der vorangehenden Ansprüche, **dadurch gekennzeichnet, dass** im Verfahrensschritt c. die Dicke des angelagerten Widerstandsmaterials (5) bedürfnisgerecht kontrolliert erfolgt.

6. Elektrisches Verbindungselement oder Halbfabrikat mit einem Schichtaufbau mit Leiterstrukturen aus einem ersten Leitermaterial und mit mindestens einem eingebetteten Widerstand, wobei der Widerstand durch eine strukturierte Lage aus einem Widerstandsmaterial gebildet wird, wobei das Verbindungselement oder Halbfabrikat mindestens bereichsweise eine erste isolierende Schicht (1) und daran haftend eine zweite isolierende Schicht (7, 6) aufweist, und die strukturierte Lage aus dem Widerstandsmaterial sich im Schichtaufbau zwischen der ersten und der zweiten isolierenden Schicht befindet und von einer benachbarten Lage mit Leiterstrukturen aus dem ersten Leitermaterial über mindestens einen Durchsteiger kontaktiert wird, **dadurch gekennzeichnet, dass** der mindestens eine eingebettete Widerstand zwei Endportionen (2.1, 2.2) und dazwischen eine Übergangsportion (2.3) aufweist und dass bei den Endportionen das Widerstandsmaterial (5) erstes Leitermaterial teilweise umhüllt, wobei der Durchsteiger ein erstes Leitermaterial aufweist, und dass im Bereich der Endportionen (2.1, 2.2) ein Übergang zwischen dem ersten Leitermaterial des Durchsteigers und dem vom Widerstandsmaterial teilweise umhüllten ersten Leitermaterial vorhanden ist.

7. Elektrisches Verbindungselement nach Anspruch 6, **dadurch gekennzeichnet, dass** das erste Leitermaterial Kupfer oder eine Kupferlegierung und das Widerstandsmaterial Nickel oder eine Nickellegierung ist.

## Claims

1. A method for manufacturing an electrical connecting element or a semifinished product with at least one electrical resistor, comprising the following method steps
a. providing a starting product with an electrically insulating layer (1) and a first conductor layer of a first conductor material adhering thereto on a first side;
b. structuring the first conductor layer (2);
c. selectively attaching a resistance material (5) on the structured first conductor layer (2);
d. applying the thus formed layer system to a carrier (6), such that the first side of the electrically insulating layer is facing the carrier;
e. removing the first conductor material and the insulating layer (1) at those locations at which the at least one electrical resistor is to be formed,
wherein a second structured conductor layer (3) is present or produced on a second side of the insulating layer, and wherein method includes the further step of contacting the resistor or the resistors from the second structured conductor layer by way of vias.

2. Method according to claim 1, **characterized** the selective removal of the insulating layer is effected with a plasma etching method.

3. Method according to claim 1 or 2, **characterized in that** the starting product comprises the insulating layer (3) adhering to the insulating layer (1) and that this second conductor layer (3) is prestructured before the selective removal of the insulating layer (1) and serves as mask for the selective removal of the insulating layer (1).

4. Method according to claim 3, **characterized** the second conductor layer (3) after the selective removal of the insulating layer (3), is structured such that a conductor path pattern of the second structured conductor layer (3) is formed.

5. Method according to one of the preceding claims, **characterized in that** in method step c. the thickness of the attached resistance material (5) is effected in a controlled manner according to requirements.

6. An electrical connecting element or semifinished product with a layered construction with conductor structures of a first conductor material and with at least one embedded resistor, wherein the resistor is formed by a structured layer from a resistance material, wherein the connecting element or semifinished product at least in regions comprises a first insulating layer (1) and a second insulating layer adhering thereto, and the structured layer of the resistance material, in the layered construction, is located between the first and the second insulating layer and is contacted from an adjacent layer with conductor structures of the first conductor material by way of at least one via, **characterized in that** the at least one embedded resistor comprises two end portions (2.1, 2.2) and a transition portion (2.3) therebetween and that the resistance material (5) partly envelops first conductor material at the end portions, wherein the via comprises first conductor material, and wherein a transition between the first conductor material of the via and the first conductor material partly enveloped by the resistance material forms in the region of the end portions. (2.1., 2.2).

7. The electrical connecting element according to claim 6, **characterized in that** the first conductor material is copper or a copper alloy and the resistance material is nickel or a nickel alloy.

## Revendications

1. Procédé de fabrication d'un élément de raccordement électrique ou d'un produit semi-fini qui présente au moins une résistance électrique, lequel procédé présente les étapes suivantes :
a. mettre à disposition d'un produit de départ qui présente une couche électriquement isolante (1) et sur un premier côté de cette dernière une première couche conductrice (2) en un premier matériau conducteur,
b. structuration de la première couche conductrice (2),
c. dépôt sélectif d'un matériau de résistance (5) sur la première couche conductrice (2) structurée,
d. placement du système ainsi obtenu sur un support (6), de telle sorte que le premier côté de la couche électriquement isolante soit tourné vers le support,
e. enlèvement du premier matériau conducteur et de la couche isolante (1) aux emplacements sur lesquels au moins une résistance électrique doit être formée,
dans lequel une deuxième couche conductrice structurée (3) est présente ou formée sur le deuxième côté de la couche isolante et le contact avec la résistance depuis la deuxième couche conductrice structurée est assuré par des traversées ("vias").

2. Procédé selon la revendication 1, **caractérisé en ce que** l'enlèvement sélectif de la couche isolante est réalisé avec un procédé de gravure au plasma.

3. Procédé selon les revendications 1 ou 2, **caractérisé en ce que** la deuxième couche conductrice (3) adhère au deuxième côté de la couche isolante (1) du produit de départ et **en ce que** cette deuxième couche conductrice (3) est pré-structurée avant l'enlèvement sélectif de la couche isolante (1) et sert de masque lors de l'enlèvement de la couche isolante (1).

4. Procédé selon la revendication 3, **caractérisé en ce que** la deuxième couche conductrice (3) est structurée après l'enlèvement de la couche isolante de telle sorte que l'on obtient un motif de pistes conductrices sur la deuxième couche conductrice structurée (3).

5. Procédé selon l'une des revendications précédentes, **caractérisé en ce que** dans l'étape c. du procédé, l'épaisseur du matériau de résistance (5) déposé est contrôlée en fonction des besoins.

6. Elément de raccordement électrique ou produit semi-fini qui présentent une structure stratifiée dotée de structures conductrices en un premier matériau conducteur et dans laquelle au moins une résistance est incorporée, la résistance étant formée d'une couche structurée en un matériau de résistance, l'élément de raccordement ou produit semi-fini présentant sur au moins certaines de ses parties une première couche isolante (1) sur laquelle adhère une deuxième couche isolante (7, 6) et la couche structurée en le matériau de résistance étant situé dans la structure stratifiée entre la première et la deuxième couche isolante et étant mis en contact par au moins une traversée avec une couche voisine dotée de structures conductrices,
**caractérisé en ce que**
la ou les résistances incorporées présentent deux parties d'extrémité (2.1, 2.2) entre lesquelles est située une partie de transition (2.3), **en ce que** sur les parties d'extrémité, le matériau de résistance (5) enrobe partiellement le premier matériau conducteur, la traversée présentant un premier matériau conducteur, et **en ce que** dans la zone occupée par les parties d'extrémité (2.1, 2.2), une transition est prévue entre le premier matériau conducteur de la traversée et le premier matériau conducteur partiellement enrobé par le matériau de résistance.

7. Elément de raccordement électrique selon la revendication 6, **caractérisé en ce que** le premier matériau conducteur est le cuivre ou un alliage de cuivre et le matériau de résistance est le nickel ou un alliage de nickel.
